# EUROPEAN PATENT SPECIFICATION

(11) **EP 0 346 055 B1**
(45) Date of publication and mention of the grant of the patent: **19.04.1995**
(21) Application number: 89305671.3
(22) Date of filing: 06.06.1989
(51) Int. Cl.: C23C 16/50, H01J 37/32

(54) **Method for causing plasma reaction under atmospheric pressure**
Verfahren zur Durchführung einer Plasmareaktion bei Atmosphärendruck
Procédé pour provoquer une réaction dans le plasma sous pression atmosphérique

(30) Priority: 06.06.1988 JP 138630/88; 04.07.1988 JP 166599/88; 15.08.1988 JP 202977/88
(43) Date of publication of application: 13.12.1989
(73) Proprietor: RESEARCH DEVELOPMENT CORPORATION OF JAPAN, Chiyoda-ku Tokyo 100 (JP)
(72) Inventor: Okazaki, Sachiko, Suginami-ku Tokyo (JP); Kogoma, Masuhiro, Wako-city Saitam (JP)
(74) Representative: Holmes, Michael John

(56) References cited:
- FR-A- 2 411 897
- PROCEEDINGS FOURTH INTERNATIONAL SYMPOSIUM ON PLASMA CHEMISTRY, vol. 2, 1979, pages 765-771, Zürich, CH; K.G. DONOHOE et al.: "Plasma polymerization of ethylene in an atmospheric pressure discharge"
- REVUE INTERNATIONALE DES HAUTES TEMPERATURES ET DES REFRACTAIRES, vol. 23, no.4, 1986, pages 205-210, Masson, Paris, FR; F. AREFI et al.: "Evolution des propriétés physicochimiques et diélectriques d'un matériau poreux type papier par encapsulation polymérique de 1,1 difluoroéthylène sous décharge couronne à la pression atmosphérique"
- PATENT ABSTRACTS OF JAPAN, vol. 10, no. 129 (E-403)[2186], 14th May 1986
- THIN SOLID FILMS, vol. 130, no. 1/2, August 1985, pages 135-154, Elsevier Sequoia, Lausanne, CH; S. VEPREK: "Plasma-induced and plasma-assisted chemical vapour deposition"

## Description

### [FIELD OF THE INVENTION]

The present invention relates to a method and apparatus for effecting plasma reactions at atmospheric pressure. More particularly, the present invention relates to a method and apparatus for forming a thin film and/or for reforming (chemically changing) the surface by means of a highly stable glow discharge plasma at atmospheric pressure.

### [BACKGROUND OF THE INVENTION]

The film forming methods and surface reforming methods based on low-pressure glow discharge plasma are widely known and industrially applied in various areas. One of the surface treatment methods using low-pressure glow discharge plasma is that known as the organic plasma reaction method for forming a thin film and/or reforming the surface by means of the conversion of an organic compound gas into plasma.

There is available, for example, a method of plasma-exciting a hydrocarbon gas in a vacuum vessel and forming by precipitation an amorphous carbon film on a silicon substrate or a glass substrate, and a method for forming a plasma polymer film of an unsaturated hydrocarbon such as ethylene.

However, all these conventional surface treatment methods based on low-pressure glow discharge plasma require an apparatus and facilities for creating low-pressure conditions because the reaction is to take place under a vacuum of about 1.33 x 10⁻³ to 1.33 x 10⁻¹ Pa (1 x 10⁻⁵ to 1 x 10⁻³ torr) in all cases, thus resulting in complicated operations and maintenance and high manufacturing costs. A low-pressure method has the further defect of difficult treatment of large-area substrates.

A system operating at atmospheric pressure is disclosed by Donohoe and Wydeven in Proc. 4th Int. Sympos. on Plasma Chemistry, 1979, 2: 765-771, but this relates to a pulsed discharge plasma polymerisation process.

With a view to overcoming these defects in the conventional methods, the present inventor carried out extensive studies and has devised a new film forming and reforming method based on glow discharge plasma at atmospheric pressure thus permitting reduction of costs for apparatus and facilities and facilitating film formation in large-area substrates. The background for this development included inventor's research on ozone producing silent discharge for many years and analysis of the reaction mechanism regarding plasma film formation.

Furthermore, the present invention is also capable of providing a solution to one problem of glow discharge plasma reactions at atmospheric pressure, namely production of arc discharge when the substrate is a conductive metal or alloy.

More specifically, the present invention provides an improved reaction method based on glow-discharge plasma at atmospheric pressure which makes available, even with a metal or alloy substrate, highly stable plasma of a highly reactive reagent gas at atmospheric pressure.

### [BRIEF DESCRIPTION OF THE DRAWINGS]

Fig. 1 is a perspective sectional view illustrating a film forming apparatus which may be used according to the present invention, having an upper electrode comprising a plurality of fine wires;
Fig. 2 is a sectional view illustrating a typical reaction apparatus suitable for use in the method of the present invention, in which a solid dielectric is provided for each of the opposing upper and lower electrodes;
Figs. 3 and 4 are bottom views illustrating a typical lower surface of the upper electrode of the present reaction apparatus;
Fig. 5 is a partially cutaway sectional view illustrating another embodiment of the upper electrode the present reaction apparatus;
Fig. 6 is a chart illustrating the relationship between the transverse distance of the substrate and thickness of a thin film deposited on the substrate when a solid dielectric is arranged on each of the upper and lower electrodes;
Fig. 7 is a sectional view illustrating further another embodiment of a reaction apparatus which may be used, in which a solid dielectric is arranged on each of the opposing upper and lower electrodes;
Figs. 8 and 9 are views illustrating an IR absorption spectral chart and an XPS depth profile, respectively, when forming an SiNₓ film according to the method of the invention; and
Figs. 10 and 11 are sectional views illustrating further another embodiment of a reaction apparatus of the present invention, in which a solid dielectric is provided on the upper electrode.

### [DETAILED DESCRIPTION OF THE INVENTION]

According to the present invention we provide a method of treating the surface of a substrate with reactive plasma which comprises exciting a reagent gas in admixture with an inert gas a reaction vessel having a pair of opposing electrodes to produce stable glow discharge plasma at atmospheric pressure, said plasma not being a pulsed discharge plasma, and the concentration of inert gas, relative to reagent gas, being greater than 65%, and causing or permitting the plasma to contact the surface of said substrate, whereby a uniform polymerised film is formed or re-formed on the surface of said substrate.

In the film forming embodiment of the method, the upper electrode preferably provides a film formation apparatus which can be suitably used for this method.

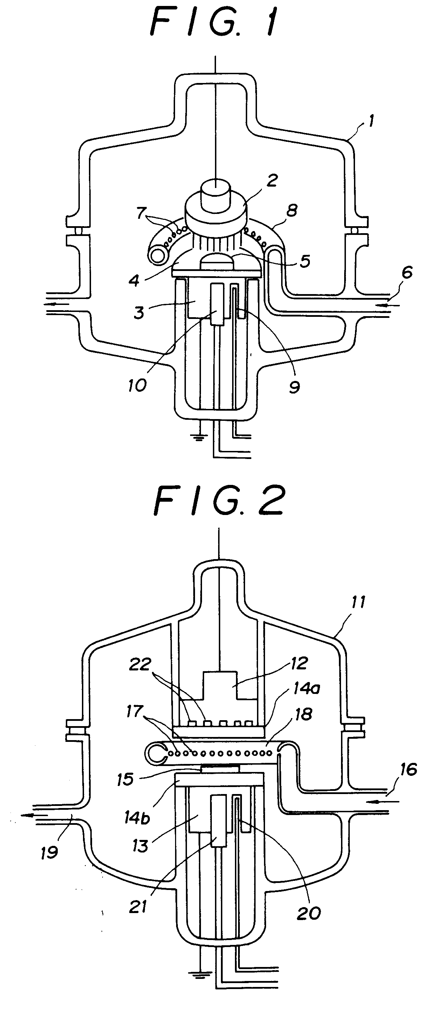

The film forming apparatus preferably has an upper electrode consisting of a multiplicity of fine vertical wires, a solid dielectric on the upper surface of a lower electrode on which the substrate is placed and a perforated pipe which uniformly diffuses gas over the surface of the substrate and its vicinity. This is shown in Fig. 1.

The apparatus shown in Fig. 1 comprises a reaction vessel consisting of a bell jar (1) made from Pyrex glass, for example, provided with an upper electrode (2) and a lower electrode (3) to which is applied a high potential difference. The upper electrode (2) consists of a plurality of fine wires arranged vertically. On the upper surface of the lower electrode (3), a solid dielectric (4) or a material such as glass, ceramics or plastics is provided. On this solid dielectric (4), a substrate (5), e..g a flat plate or the like, is placed.

A mixture of inert gas such as He, Ne, Ar, or N₂ and monomer gas such as a hydrocarbon which is a raw material for forming a thin film is introduced through inlet (6) into a perforated pipe (8) having several openings (7) so that the gas mixture diffuses uniformly from openings (7) onto the substrate (5). Unreacted gas, inert gas, etc are discharged from the gas exit of the reaction vessel.

A temperature sensor (9) and a heater (10) are provided in the lower electrode (3). A cooling device can also be installed.

In the film forming apparatus of the present invention which can be indicated in Fig. 1 above, the reaction zone in the bell jar (1) is maintained at substantially atmospheric pressure. Therefore, no vacuum device or similar equipment is required in contrast to a conventional low-pressure glow discharge plasma film formation apparatus.

Inert gases to be used in the reaction, such as He, Ne, Ar, or N₂, can be used as simple substances or as mixtures. However, to prevent arc discharge it is desirable to use He, which has the lowest ionisation potential, to begin the glow discharge. It is possible to form a desired plasma polymer film by using a suitable monomer gas mixed with the inert gas as the raw material for forming the film. The reagent gas may be selected from saturated hydrocarbons such as methane, ethane, etc. unsaturated hydrocarbons such as ethylene, propylene, etc., hydrocarbons having halogen or other functional substituents, semimetals such as Si, Ga, etc., or gaseous metal compounds.

Depending on the gas to be used, halogen, oxygen, hydrogen, nitrogen or ammonia may be mixed for the purpose of accelerating the reaction or as a reaction component for forming a SiNₓ film. The ratio of the inert gas to the reagent gas is not specially critical, but the gas concentration is desirably higher than 90%. A mixture of several kinds of gases may be used.

It is desirable to produce a plasma of the gas mixture in a state in which the gas is uniformly diffused and supplied in a plasma zone close to the substrate. To achieve this, the perforated pipe (8) shown in Fig. 1 or other suitable means may be used. Its shape and structure may be selected depending on the size of the apparatus and that of electrodes. Inflow of outside gas (oxygen, nitrogen, etc) must, in general, be prevented.

Plasma is formed by applying a high voltage between the electrodes. The voltage can be determined according to the heat resistance, forming speed, or the like of the film to be formed. The film formation speed can be controlled by adjusting frequency and voltage. For example, as shown in Fig. 1, it is possible to make the film thickness uniform, minimize differences in thickness between the central part and peripheral part of the substrate (5) and enable a stable glow discharge to be formed by using vertical fine wires for the upper electrode (2) and providing a solid dielectric (4) to the lower electrode (3). In the case of Fig. 1, a film is formed even more effectively by rotating the upper electrode (1).

Usually, glow discharge is not produced easily under atmospheric pressure; however, highly stable glow discharge and plasma formation are possible by using a inert gas, an electrode consisting of several fine wires and a solid dielectric. For the substrate (5) it is possible to use, for example, suitable material of ceramics, glass, plastics or the like.

Furthermore, this invention also offers a method and apparatus which can produce a stable glow discharge plasma reaction at atmospheric pressure, without producing arc discharge, even through a conductive material such as a metal or alloy is used as a substrate.

This invention further offers an atmospheric pressure plasma reaction method characterised by treating the surface of the substrate by plasma produced at atmospheric pressure from a monomer gas introduced into a reaction vessel having a single dielectric-covered electrode, the surface of the upper electrode being covered with a solid dielectric, or a pair of dielectric-covered electrodes, the surface of each of upper and lower electrodes being covered with a solid dielectric respectively.

As a further preferred feature, a perforated pipe is provided in the vicinity of the substrate so that reaction gas diffuses uniformly. This apparatus is shown in Fig. 2.

Fig. 2 shows an example of the reaction apparatus in which a solid dielectric is provided on each of the upper and lower electrodes. This example has an upper electrode (12) an a lower electrode (13) to which high voltage is applied in the reaction vessel consisting of a bell jar (11) made from Pyrex glass.

Heat resistant solid dielectrics (14a) and 14b) made of glass, ceramics, plastics or mica are provided on the surface of the upper electrode (12) and lower electrode (13). A substrate (15) such as a plate is placed on solid dielectric (14b) provided on the upper surface of lower electrode (13).

The reaction gas consisting of a mixture of a rare gas such as He, Ne, Ar, etc., and reagent gas is introduced into a perforated pipe (18) having many openings (17) through a reaction gas inlet (16) so that the reaction gas diffuses from openings (17) uniformly onto the substrate (15). Unreacted gas, rare gas, etc. are discharged from exit (19) of the reaction vessel.

A temperature sensor (20) and a heater (21) are provided in the lower electrode (13). Installation of a cooling device is possible.

In this example, the reaction zone in the bell jar (11) is maintained at atmospheric pressure.

In general glow discharge is not produced easily at atmospheric pressure and when the substrate (15) is metal or alloy, arc discharge tends to occur when applying high voltage, thus making surface treatment of the substrate (15) difficult. In this embodiment, however, stable glow discharge at atmospheric pressure is facilitated even though the substrate (15) is metal, alloy or a conductive material such as silicon by providing the solid dielectrics (14a) and (14b) on the surface of the upper electrode (12) and lower electrode (13) respectively as shown in Fig. 2. Of course, if the substrate (15) is ceramics, glass, plastics, or the like, highly stable glow discharge can more readily be achieved.

For reagent gas, it is possible to use an arbitrary material from among saturated or unsaturated hydrocarbons such as methane, ethane, ethylene, propylene, etc., or hydrocarbons having substituents, e.g. halogenated hydrocarbon such as CF₄, C₂F₆, CHF₃ or SF₆, or other functional substituents, or gaseous compounds of semimetals such as Si and Ga, or gaseous metal compounds. Furthermore, oxygen, halogen, hydrogen, nitrogen or ammonia may be added.

The ratio of rare gas to reagent gas is not particularly critical. However, the preferred rare gas concentration is greater than 65%, more preferably higher than 90%. Several kinds of gases may be used as the reaction gas to be introduced.

Depending on types and reaction conditions of the reagent gas to be used, plasma polymer films, plasma reformed surface films and plasma etched films can be obtained.

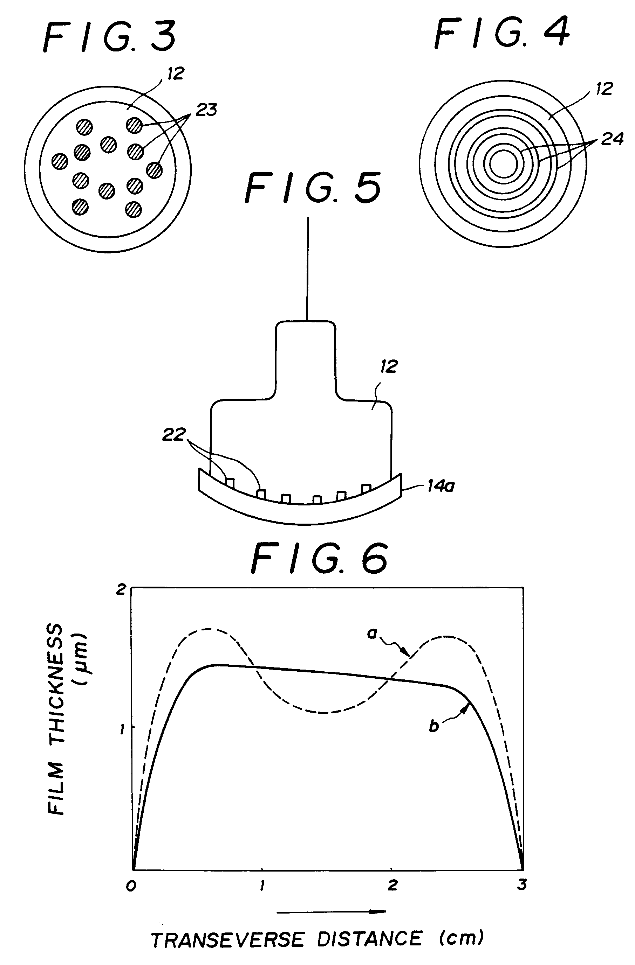

As shown in Fig. 2, it is effective to form several grooves (22) on the lower surface of upper electrode (12). These grooves (22) are effective in diffusing the glow discharge (which is liable to concentrate at the edge and in the vicinity of the upper electrode (12)), and cause the discharge to diffuse uniformly over all the surface of the upper electrode (12). By these grooves (22), localized concentration of the glow discharge is prevented. Thus, a uniform film thickness is formed or uniform surface treatment is achieved on the surface of the substrate (15). The depth of these grooves (22) may be 1 to 2 mm. Furthermore, it is possible to decide the shape of these grooves (22) depending on the shape and properties of the substrate (15). For example, the grooves (22) may comprise several holes (23) as shown in Fig. 3 or several concentric circular grooves (24) as shown in Fig. 4.

The shape of an upper electrode (12) may be changed as shown in fig. 5. By this change, it is possible to increase the uniformity of the surface treatment.

Production of glow discharge has been difficult at atmospheric pressure. However, highly stable glow discharge and formation of plasma become possible by using rare gas, providing solid dielectric on each of the electrodes and forming several grooves on the lower surface of the upper electrode. A suitable material of metal, alloy, ceramics, glass, plastics, or the like can be used as the substrate (15) shown in Fig. 2.

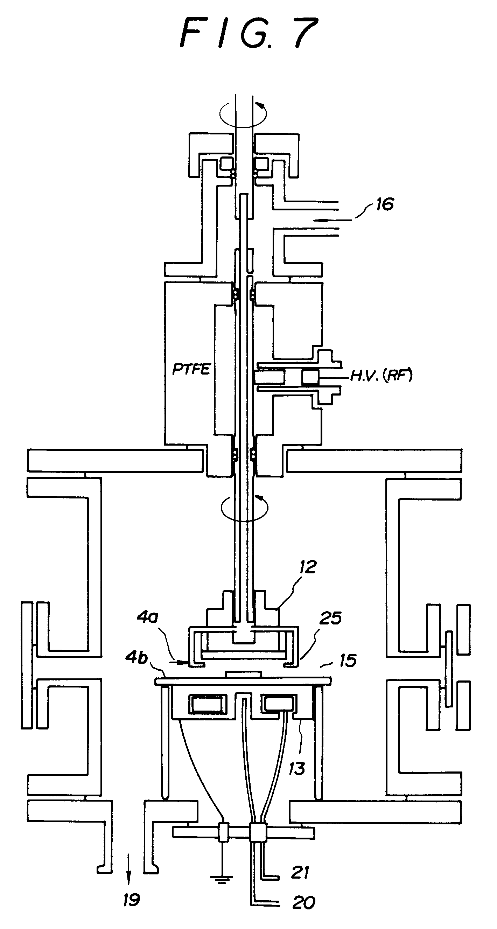

Fig. 7 shows an example of the reaction apparatus having a different structure from Fig. 2. The upper electrode (12) rotates and reagent gas is introduced into the reaction zone through gas nozzle (25).

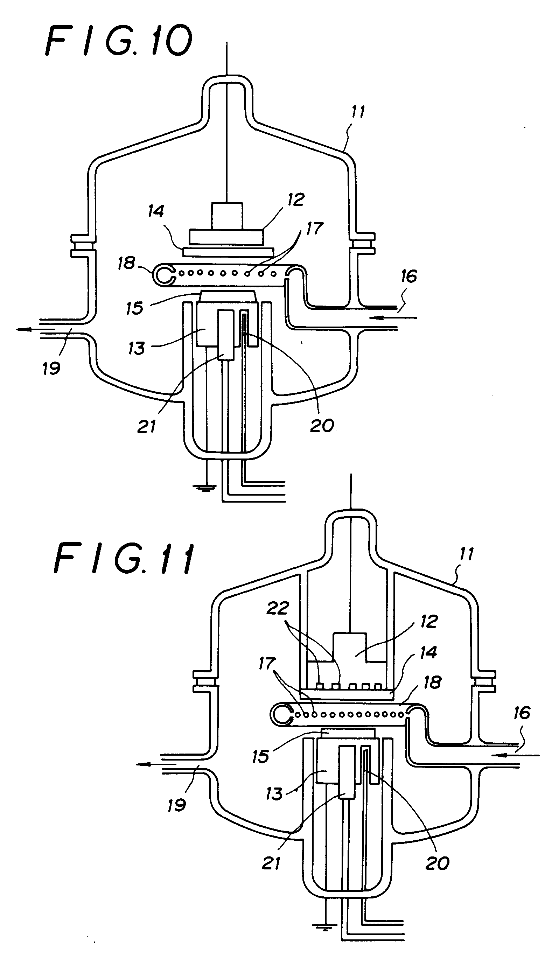

Fig. 10 shows an example in which the solid dielectric is provided only on the upper electrode. In other words, a heat resistant solid dielectric such as glass, ceramics, plastics or mica is provided on the surface of the upper electrode (12). The substrate (15) such as plate body is placed onto the upper surface of the lower electrode (13).

To obtain more stable plasma under the atmospheric pressure, it is effective to form several grooves (22) on the lower surface of the upper electrode (12) as shown in Fig. 11.

The grooves (22) are for uniformly diffusing the glow discharge which is liable to concentrate at the edge and in the vicinity of the upper electrode (12), in Fig. 2, and cause glow discharge to diffuse over all parts of the surface of the upper electrode (12). By these grooves (22), it is possible to prevent localized concentration of glow discharge, and to produce uniformly diffused stable glow discharges thus forming a uniform film thickness over the substrate (15) or to achieve uniform surface treatment.

The present invention is described further in detail by means of the following examples which are given by way of illustration only:-

### EXAMPLE 1

With the use of the apparatus shown in Fig. 1 (electrode diameter: 30 mm, distance between electrodes: 10 mm), a polyethylene film was formed from ethylene monomer under the following conditions:
(a) Gas mixture:
   - He :: : 4,500 SCCM
   - Ethylene: : 3.6 SCCM
(b) Glow discharge:
   Atmospheric pressure,
   3,000 Hz, 1.05 kV, 3 mA,
(c) Substrate:
   Cover glass

A polyethylene film was obtained on the substrate surface at a film forming rate of 12,500 Å/2 hr (1.25»m/2hr i.e. 0.625»m/h). The film was transparent, with satisfactory adhesion.

### EXAMPLE 2

A polyethylene film was formed in the same manner as in Example 1 under the following conditions:
(a) Gas mixture:
   - He :: : 4,500 SCCM
   - Ethylene: : 6.0 SCCM
(b) Glow discharge:
   Atmospheric pressure,
   3,000 Hz, 1.25 kV, 6 mA,
(c) Substrate:
   Cover glass

A polyethylene film was obtained at a film forming rate of 2,100 Å/2 hr (0.21»m/2hr i.e. 0.105»m/h). The film was transparent, with satisfactory adhesion.

### EXAMPLE 3

A polyethylene film was formed in the same manner as in Example 1 under the following conditions:
(a) Gas mixture:
   - He :: : 4,500 SCCM
   - Ethylene: : 2.5 SCCM
(b) Glow discharge:
   Atmospheric pressure,
   3,000 Hz, 1.01 kV, 2.2 mA,
(c) Substrate:
   Cover glass

A polyethylene film was obtained at a film forming rate of 16,800 Å/5.5 hr (1.68»m/5.5 hr i.e. 0.305»m/h). The film was transparent, with a satisfactory adhesion.

### EXAMPLE 4

A polyethylene film was formed in the same manner as in Example 1 under the following conditions:
(a) Gas mixture:
   - He :: : 4,500 SCCM
   - Ethylene: : 3.6 SCCM
(b) Glow discharge:
   Atmospheric pressure,
   3,000 Hz, 1.1 kV, 3 mA,
(c) Substrate:
   0.2 mm-thick quartz glass

A polyethylene film was obtained at a film forming rate of 9,000 Å/2 hr (0.9»m/2hr i.e. 0.45»m/h). The film was transparent, with a satisfactory adhesion.

### EXAMPLE 5

In the apparatus as shown in Fig. 2 using heat-resistant captone-covered electrodes having a diameter of 30 mm and a distance between electrodes of 10 mm (with no grooves (22)), a polyethylene film was formed from ethylene monomer under the following conditions:
(a) Reaction gas concentration (%):
   Ethylene/He = 95/5
(b) Discharge:
   Atmospheric pressure,
   3,000 Hz, 1.05 kV, 3 mA,
(c) Substrate:
   Aluminum substrate
A polyethylene film was thus formed on the surface of the aluminum substrate at a film forming rate of 11,417 Å/2 (1.1417»m/2hr i.e. 0.5709»m/h). The film was transparent, with excellent adhesion and a uniform film thickness.

In this Example, highly stable glow discharge took place without the occurrence of arc discharge, thus making available high-activity and high-stability plasma.

### EXAMPLE 6

In the same manner as in Example 5, a polyethylene terephtalate film was treated under the following conditions, to make the surface thereof hydrophobic. Formation of a carbonfluorine reformed film was confirmed.
(a) Reaction gas concentration (%):
   CF₄/He = 91.6/8.4,
   - CF₄: : 0.16 ml/s (10 ml/min),
   - He: : 3.61 ml/s (216.7 ml/min),
(b) Discharge:
   Atmospheric pressure,
   3,000 Hz, 3.46 to 3.75 k.V, 8 mA,

The relationship between the treatment time and the contact angle is shown in Table 1. For comparison purposes, the contact angle for an untreated case is also shown in Table 1.

The surface having become hydrophobic was thus confirmed, with a uniform degree of treatment.

**Table 1**

| Treating time | 30 sec | 1 min | 5 min | Untreated |
|---|---|---|---|---|
| Contact angle | 95.5° | 96.0° | 98.0° | 64° |

### EXAMPLE 7 and 8

The same treatment as in Example 6 was applied to a conductive graphite (already wrapped) as the substrate, under the conditions as shown in Table 2.

The measurement of the contact angle in these Examples permitted confirmation of a high degree of hydrophobicity. The result is shown in Table 2.

In an apparatus comprising electrodes not using solid dielectric, production of arc discharge made it impossible to carry out the plasma treatment.

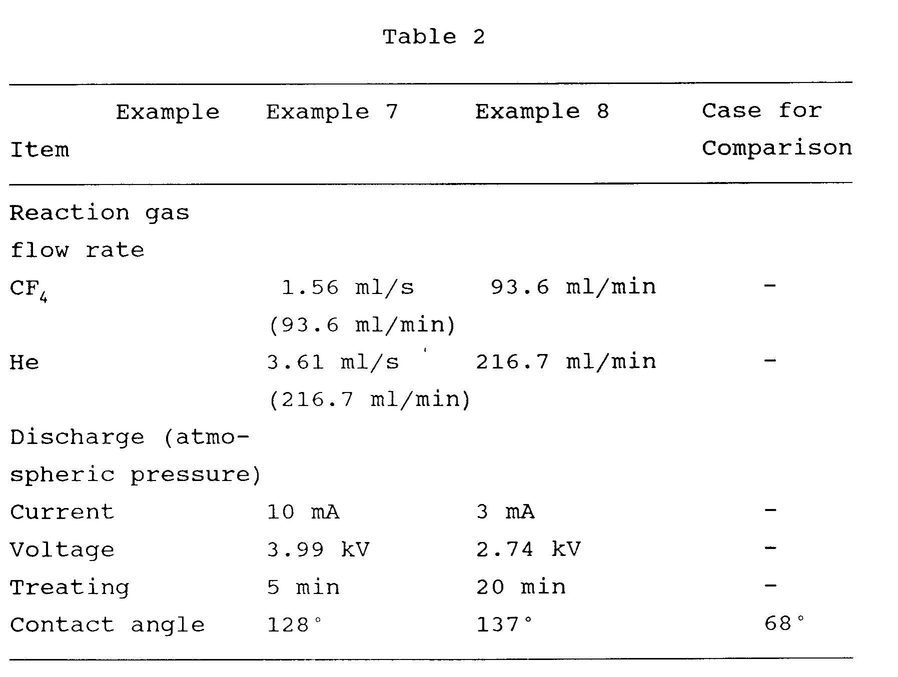

### EXAMPLE 9 and 10

With the use of the reaction apparatus shown in Fig. 2, with grooves (22) in one case and without grooves (22) in another case, a plasma-polymerized polyethylene film was formed on a silicon substrate.
(a) Reaction gas (%):
   - C₂H₄: : 0.06 ml/s (3.6 ml/min),
   - He: : 74.92 ml/s (4,495 ml/min),
(b) Discharge:
   3,000 Hz, 1.5 hr,
   Atmospheric pressure, room temperature.

The relationship between the transverse distance of the silicon substrate and the thickness of the plasma-polymerized polyethylene film is shown in Fig. 6.

As is clear from Fig. 6, comparing the case (a) using the reaction apparatus without grooves (22), with the case (b) using an upper electrode with a concentric circular grooves (24) (as shown in Fig. 4) shows that the latter permits more uniform film thickness distribution, suggesting that plasma is stabilized over the entire surface of the substrate.

### EXAMPLE 11

A SiNₓ film was formed with the use of the apparatus shown in Fig. 7 under the following reaction conditions:
- He: : 83.33 ml/s (5,000 ml/min),
- H₂: : 0.33 ml/s (20 ml/min),
- N₂: : 0.33 ml/s (20 ml/min),
- SiCl₄: : 4.5 mg/min,
- Pressure: : Atmospheric pressure,
- RF: : 13.56 MHz, 220 W,
- Temperature: : 440°C
- Substrate: : Si Wafer.

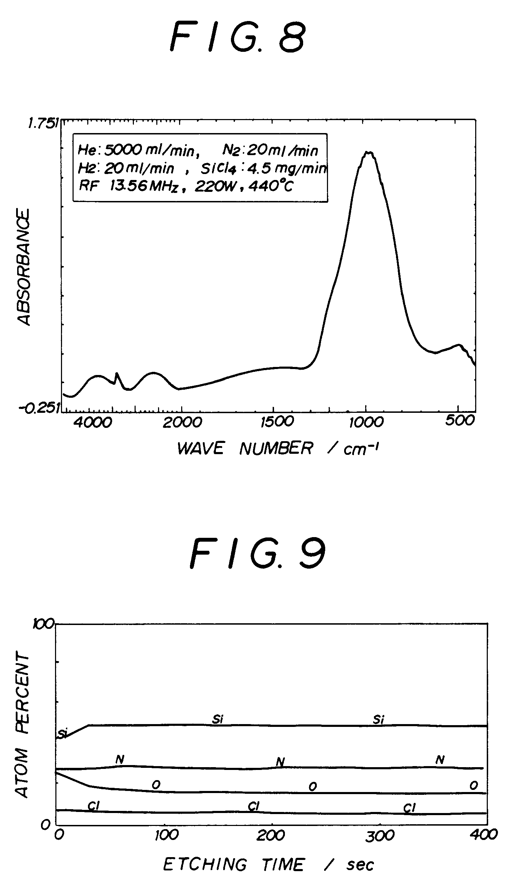

Fig. 8 illustrates the difference in IR of the SiNₓ film thus obtained from the silicon substrate.

As Si-N expansion-concentration movement is observed at about 850 cm⁻¹, and an Si-O expansion-contraction movement, at 1020-1090 cm⁻¹.

Fig. 9 shows the result of XPS analysis in the depth direction of the SiNₓ film, which permits confirmation that nitrogen is contained in a large quantity. The film has the composition SiNₓO_{y}, and the content of oxygen thereof is controllable.

### EXAMPLE 12

With the use of the apparatus shown in Fig. 10 using heat-resistant captone-covered electrodes having a diameter of 30 mm and a distance between electrodes of 10 mm, a polyethylene film was formed from ethylene monomer under the following conditions:
(a) Reaction gas flow rate:
   - C₂H₄: : 3.0 SCCM,
   - He: : 4,500 SCCM,
(b) Discharge:
   Atmospheric pressure, room temperature,
   3,000 Hz, 1.0 kV,
   1 to 5 mA (gradually increased),
(c) Substrate:
   Silicon substrate
A polyethylene film was formed on the silicon substrate at a film forming rate of 10,000 to 20,000 Å/hr (ie. 1.0 to 2.0 »m/h). The film was transparent, with satisfactory adhesion and a uniform film thickness.

In this example, highly stable and uniformly dispersed glow discharge took place without the occurrence of arc discharge, thus making available high-activity and high-stability plasma.

### EXAMPLE 13

In the same manner as in Example 12, a polyethylene terephthalate film was formed under the following conditions to make the surface thereof hydrophobic:
(a) Reaction gas flow rate:
   - CF₄: : 25 SCCM,
   - He: : 210 SCCM,
(b) Discharge:
   Atmospheric pressure,
   3,000 Hz, 3.5 kV,
   2 to 8 mA (gradually increased).

The contact angle was measured five minutes after the start of treatment. The result showed a contact angle of 98°C. A non-treated film had a contact angle of 64°. The surface having become hydrophobic was thus confirmed. Treatment was uniform.

### EXAMPLE 14

The same manner as in Example 13 was applied to a conductive graphite (already wrapped) as the substrate.
(a) Reaction gas flow rate:
   - CF₄: : 96 SCCM,
   - He: : 220 SCCM,
(b) Discharge:
   Atmospheric pressure,
   3,000 Hz, 2.8 kV,
   3 to 5 mA (gradually increased).

The contact angle was measured 15 minutes after the start of treatment. The result showed a contact angle of 131°C. A non-treated film had a contact angle of 68°. The surface having become hydrophobic was confirmed. Treatment was uniform. In this Example, highly stable and uniformly dispersed glow discharge took place without the occurrence of arc discharge as in the Example 12, thus making available high-activity and high-stability plasma.

The present invention is not limited to the above-mentioned examples. Variations are possible within the framework of the present invention in such details as the size and shape of the reaction vessel, the structure, configuration and shape of the electrodes, the shape and number of grooves on the lower surface of the upper electrode, and the structure and configuration of the reaction gas supply.

According to the present invention, as described above in detail, it is possible, as compared with the conventional low-pressure glow discharge plasma reaction, to eliminate the necessity of an apparatus and facilities for forming a vacuum system, reduce the cost, and carry out film formation and/or surface treatment under the atmospheric pressures, requiring only a relatively simple structure and configuration of the apparatus and facilitating treatment of a large-area substrate because the substrate can be set directly on the upper surface of the lower electrode.

Furthermore, the present invention allows film formation and/or surface treatment without limiting the material, shape and properties of the substrate and makes available uniform film thickness and surface condition in a thin film so obtained.

## Claims

1. A method of treating the surface of a substrate with reactive plasma which comprises exciting a reagent gas in admixture with an inert gas in a reaction vessel having a pair of opposing electrodes to produce stable glow discharge plasma at atmospheric pressure, said plasma not being a pulsed discharge plasma, and the concentration of inert gas, relative to reagent gas, being greater than 65%, and causing or permitting the plasma to contact the surface of said substrate, whereby a uniform polymerised film is formed or re-formed on the surface of said substrate.

2. A method as claimed in claim 1, wherein a thin film is formed on the surface of said substrate.

3. A method as claimed in claim 1, wherein the surface of said substrate is chemically changed.

4. A method as claimed in claim 1, for forming a thin film on a substrate which comprises introducing a monomer gas in admixture with an inert gas into a reaction vessel having an upper electrode comprising a plurality of fine wires to convert the gas into plasma at atmospheric pressure, thereby forming a thin film on the surface of the substrate.

5. A method as claimed in claim 4, wherein a solid dielectric is provided on the upper surface of a lower electrode on which said substrate is to be set.

6. A method as claimed in claim 1, which comprises introducing a mixture of a rare gas and a monomer gas into a reaction vessel having a pair of dielectric-covered electrodes formed by providing a solid dielectric on the surface of each of an upper electrode and a lower electrode, and exciting the gas to form plasma at atmospheric pressure, thereby treating the surface of a substrate on said vessel.

7. A method as claimed in claim 1, which comprises introducing a reagent gas into a reaction vessel having a single dielectric-covered electrode comprising an upper electrode, the surface of which is covered with a solid dielectric, and plasma-exciting said reagent gas at atmospheric pressure, thereby treating the surface of a substrate in said vessel.

8. A method as claimed in any one of claims 1 to 7 for the preparation of a film selected from polyalkylene or polyfluoroalkylene polymerized films, SiNₓ films, amorphous carbon or amorphous silicon films or carbon-fluorine reformed films, wherein said reagent gas comprises unsaturated or saturated hydrocarbons, halogenated, preferably fluorinated, hydrocarbons, SF₆, nitrogen, ammonia or gaseous compounds of Si.

9. A method as claimed in claim 1 for the preparation of a SiNₓ film wherein ammonia is present in the reagent gas mixture.

## Patentansprüche

1. Verfahren zur Behandlung der Oberfläche eines Substrates mit einem reaktiven Plasma, bei dem man ein einem Inertgas beigemischtes, reagierendes Gas in einem Reaktionsgefäß anregt, das ein Paar sich gegenüberliegende Elektroden aufweist, um ein stabiles Glühentladungsplasma bei Atmosphärendruck zu erzeugen, wobei das Plasma kein pulsierendes Entladungsplasma ist und die Konzentration des Inertgases, bezogen auf das reagierende Gas, größer als 65 % ist, und bei dem man das Plasma mit der Oberfläche des Substrates in Kontakt treten läßt, wodurch auf der Oberfläche des Substrats ein gleichmäßig polymerisierter Film gebildet oder umgewandelt wird.

2. Verfahren gemäß Anspruch 1, worin ein dünner Film auf der Oberfläche des Substrats gebildet wird.

3. Verfahren gemäß Anspruch 1, worin die Oberfläche des Substrats chemisch verändert wird.

4. Verfahren gemäß Anspruch 1, zur Erzeugung eines dünnen Films auf einem Substrat, bei dem man ein einem Inertgas beigemischtes, monomeres Gas in ein Reaktionsgefäß leitet, das eine obere Elektrode besitzt, die eine Vielzahl dünner Drähte zur Umwandlung des Gases in ein Plasma bei Atmosphärendruck umfaßt, wodurch man einen dünnen Film auf der Oberfläche des Substrats bildet.

5. Verfahren gemäß Anspruch 4, worin ein festes Dielektrikum auf der Oberseite einer unteren Elektrode angeordnet ist, auf welches das Substrat gelegt werden soll.

6. Verfahren gemäß Anspruch 1, bei dem man eine Mischung aus einem Edelgas und einem monomeren Gas in ein Reaktionsgefäß leitet, das ein Paar mit dielektrischem Material beschichtete Elektroden aufweist, die durch Anordnung eines festen Dielektrikums auf der Oberfläche sowohl einer oberen Elektrode als auch einer unteren Elektrode gebildet wurden, und bei dem man das Gas zur Erzeugung eines Plasmas bei Atmosphärendruck anregt, wodurch man die Oberfläche eines Substrats in dem Gefäß behandelt.

7. Verfahren gemäß Anspruch 1, bei dem man ein reagierendes Gas in ein Reaktionsgefäß einleitet, das eine einzelne mit dielektrischem Material beschichtete Elektrode aufweist, die eine obere Elektrode umfaßt, deren Oberfläche mit einem festen Dielektrikum bedeckt ist, und bei dem man eine Plasmaanregung des reagierenden Gases bei Atmosphärendruck durchführt, wodurch man die Oberfläche eines Substrats in dem Gefäß behandelt.

8. Verfahren gemäß einem der Ansprüche 1 bis 7 zur Herstellung eines Films, der ausgewählt ist aus polymeren Polyalkylen- oder Polyfluoralkylen-Filmen, SiNₓ-Filmen, Filmen aus amorphem Kohlenstoff oder amorphem Silicium oder aus umgewandelten Fluorkohlenstoff-Filmen, wobei das reagierende Gas ungesättigte oder gesättigte Kohlenwasserstoffe, halogenierte, vorzugsweise fluorierte Kohlenwasserstoffe, SF₆, Stickstoff, Ammoniak oder gasförmige Siliciumverbindungen umfaßt.

9. Verfahren gemäß Anspruch 1 zur Herstellung eines SiNₓ-Films, worin Ammoniak in der reagierenden Gasmischung vorhanden ist.

## Revendications

1. Procédé de traitement de la surface d'un substrat avec un plasma réactif, selon lequel on excite un gaz réactif mélangé avec un gaz inerte, dans un réacteur comportant une paire d'électrodes opposées afin de produire un plasma de décharge luminescente stable à la pression atmosphérique, ce plasma n'étant pas un plasma de décharge par impulsions, et la concentration en gaz inerte par rapport au gaz réactif étant supérieure à 65 %, et on provoque ou on permet le contact du plasma avec la surface du substrat, de façon qu'un film polymérisé uniforme soit formé ou modifié sur la surface de ce substrat.

2. Procédé selon la revendication 1, dans lequel un mince film est formé sur la surface du substrat.

3. Procédé selon la revendication 1, dans lequel la surface du substrat est chimiquement modifiée.

4. Procédé selon la revendication 1, pour la formation d'un film mince sur un substrat, selon lequel on introduit un gaz monomère en mélange avec un gaz inerte dans un réacteur comportant une électrode supérieure comprenant plusieurs fils métalliques fins, afin de convertir le gaz en un plasma sous pression atmosphérique, et former un film mince sur la surface du substrat.

5. Procédé selon la revendication 4, dans lequel un diélectrique solide est prévu sur la surface supérieure d'une électrode inférieure sur laquelle le substrat est destiné à être disposé.

6. Procédé selon la revendication 1, dans lequel on introduit un mélange d'un gaz rare et d'un gaz monomère dans un réacteur comportant une paire d'électrodes revêtues d'un diélectrique, formées en déposant un diélectrique solide respectivement sur la surface d'une électrode supérieure et d'une électrode inférieure, et on excite le gaz pour former un plasma sous pression atmosphérique, et traiter ainsi la surface d'un substrat présent dans le reacteur.

7. Procédé selon la revendication 1, qui comprend l'introduction d'un gaz réactif dans un réacteur ayant une seule électrode recouverte de diélectrique comprenant une électrode supérieure, dont la surface est recouverte d'un solide diélectrique et on excite le gaz réactif pour former un plasma à la pression atmosphérique et traite ainsi la surface d'un substrat présent dans le réacteur.

8. Procédé selon l'une quelconque des revendications 1 à 7 pour la préparation d'un film choisi parmi des films polymérisés de polyalkylène ou de polyfluoroalkylène, des films de SiNₓ, les films de carbone amorphe ou de silicium amorphe ou des films modifiés de carbone et de fluor, dans lequel ledit gaz réactif comprend des hydrocarbures insaturés ou saturés, des hydrocarbures halogénés de préférence fluorés, SF₆, de l'azote, de l'ammoniaque ou un composé gazeux de Si.

9. Procédé selon la revendication 1, pour la préparation d'un film de SiNₓ, dans lequel de l'ammoniaque est présent dans le mélange gazeux réactionnel.
